# EUROPEAN PATENT APPLICATION

(11) **EP 2 960 357 A1**
(43) Date of publication of application: **30.12.2015**
(21) Application number: 13875455.1
(22) Date of filing: 25.11.2013
(51) Int. Cl.: C23C 14/35, C23C 14/10

(54) **FILM FORMATION METHOD AND FILM FORMATION DEVICE**

(30) Priority: 21.02.2013 JP 2013031972
(71) Applicant: Chugai Ro Co., Ltd., Osaka-shi Osaka 541-0046 (JP)
(72) Inventor: FURUYA, Eiji, Osaka-shi, Osaka 541-0046 (JP); KOYAMA, Ryousuke, Osaka-shi, Osaka 541-0046 (JP)
(74) Representative: Glawe, Delfs, Moll
(86) International application number: PCT/JP2013/081650
(87) International publication number: WO 2014/129039

(57) **Abstract**

Provided is a method and a device capable of performing film formation of a transparent film without any color using SiO of a sublimating type allowing uniform vapor deposition as a target material. The method includes the steps of: preparing a substrate 13 such that a vapor deposition surface 13a of the substrate 13 faces an interior of a film formation chamber 12; providing a magnet 29 for a back surface of the substrate 13; placing SiO on a crucible 21 disposed in the film formation chamber 12; irradiating the SiO as a target material 22 with plasma by a plasma generating device 11 to evaporate SiO; defining a plasma confining space 35 on a side of the vapor deposition surface 13a of the substrate 13 by a magnetic field of the magnet 29; and forming SiO₂ by causing reaction of the evaporated SiO with plasma in the plasma confining space 35 and activating SiO, and thus forming an SiO₂ film over the vapor deposition surface 13a of the substrate 13 without using oxygen as a reaction gas.

## Description

### TECHNICAL FIELD

The present invention relates to a film formation method and a film formation device of forming a thin film over a substrate based on an ion plating method.

### BACKGROUND ART

According to a film formation method based on an ion plating method, while plasma is irradiated to a target material in a crucible placed within a reaction chamber by a plasma gun to evaporate the target material, a reaction gas is introduced into the reaction chamber to react with the target material, and the reacted target material is vapor-deposited on the substrate. If the reaction between the target material and the reaction gas is insufficient, a low-quality film is formed. In order to improve the film quality, it is possible to take measures such as increasing a flow rate of the reaction gas, decreasing a speed for film formation, or heating the substrate.

However, as an amount of the gas that can be introduced is limited, increasing the flow rate of the reaction gas also increases a film formation pressure and thus decreases the speed of film formation, resulting in an increase in defects. Decreasing the speed for film formation results in low productivity. Heating the substrate may not be employed for resin films, and involves physical limitation in heating.

SiO is generally used as a target material when forming a transparent insulating film made of SiO₂. This is because using SiO₂ as a target material causes SiO₂ to melt into a liquid state, instead of sublimating, and therefore it is not possible to perform uniform and stable vapor deposition, and maintaining the speed of film formation becomes difficult. By contrast, as SiO sublimates, it is possible to perform uniform and stable vapor deposition. However, as the color of the material is black, it is not possible to form a transparent film unless oxygen is added to SiO to turn SiO into SiO₂. Therefore, when SiO is used as a target material, oxygen is used as a reaction gas. However, if reaction between oxygen and SiO is insufficient, a film may not be made of SiO₂ and a colored film is formed.

Patent Document 1 proposes formation of a precise and high-quality film over a substrate by disposing a magnet along an inner wall of a film formation drum, providing a plasma confining section over a surface of the substrate, and activating a material for film formation. However, the method according to Cited Reference 1 uses SiO₂ as a target material. The plasma confining space defined by the magnet according to the method of Cited Reference 1 is not designed for sufficient reaction between oxygen and SiO when using SiO as a target material and oxygen as a reaction gas.

As a method similarly using a magnet, Patent Document 2 proposes to prevent a film substrate from being damaged, by disposing a permanent magnet within a film formation drum at a position near a position where the film substrate is separated from the film formation drum, and by reducing an electrostatic force when the film substrate is separated from the film formation drum. However, the method according to Patent Document 2 is not directly related to the quality of the film at the time of film formation.

In the field of film formation, in view of the above circumstances, it is demanded for a method capable of forming a transparent film using SiO allowing uniform vapor deposition as a target material, and without using a reaction gas (oxygen) that is difficult to control.

### PRIOR ART DOCUMENTS

### PATENT DOCUMENTS

Patent Document 1: Japanese Patent Laid-open Publication No. JP 2006-124738 (Japanese Patent No. JP 4613046)
Patent Document 2: Japanese Patent Laid-open Publication No. JP 2008-075164 (Japanese Patent No. JP 4826907)

### SUMMARY OF THE INVENTION

### PROBLEMS TO BE SOLVED BY THE INVENTION

An object of the present invention is to provide a method and a device capable of performing film formation of a transparent film without any color using SiO of a sublimating type allowing uniform vapor deposition as a target material.

### SOLUTIONS TO THE PROBLEMS

As a result of diligent investigation for a method capable of performing film formation of a transparent film without using oxygen as a reaction gas when SiO is used as a target material, the inventors of the present invention have found that it is possible to perform film formation of a transparent film by forming SiO₂ based on activation of SiO with plasma in a plasma confining space defined by a magnet provided for a back surface of a substrate.

In order to achieve the afore-mentioned object, a film formation method according to the present invention includes the steps of: preparing a substrate such that a vapor deposition surface of the substrate faces an interior of a film formation chamber; providing a magnet for a back surface of the substrate; placing SiO on a crucible disposed in the film formation chamber; irradiating the SiO with plasma by a plasma generating device to evaporate SiO; defining a plasma confining space on a side of the vapor deposition surface of the substrate by a magnetic field of the magnet; and forming SiO₂ by causing reaction of the evaporated SiO with plasma in the plasma confining space and activating SiO, and thus forming an SiO₂ film over the vapor deposition surface of the substrate without using oxygen as a reaction gas.

According to this method, as SiO is activated by causing reaction of the evaporated SiO with plasma in the plasma confining space, a film of SiO₂ may be formed over the vapor deposition surface of the substrate without using oxygen as a reaction gas. In other words, it is possible to perform film formation of a transparent film without any color using SiO of a sublimating type allowing uniform vapor deposition as the target material.

In order to achieve the afore-mentioned object, a film formation device according to the present invention is capable of performing film formation by irradiating a target material placed on a crucible in a film formation chamber with plasma by a plasma generating device to evaporate the target material, and performing vapor deposition of the evaporated target material over a substrate provided such that a vapor deposition surface of the substrate faces an interior of the film formation chamber, wherein an SiO₂ film is formed over the vapor deposition surface of the substrate without using oxygen as a reaction gas by: providing a magnet for a back surface of the substrate, defining a plasma confining space on a side of the vapor deposition surface of the substrate by a magnetic field of the magnet, and placing SiO as a target material on the crucible; and irradiating the SiO with plasma by a plasma generating device to evaporate SiO, and forming SiO₂ by causing reaction of the evaporated SiO with plasma in the plasma confining space and activating SiO.

According to this configuration, as SiO is activated by causing reaction of the evaporated SiO with plasma in the plasma confining space, a film of SiO₂ may be formed over the vapor deposition surface of the substrate without using oxygen as a reaction gas. In other words, it is possible to perform film formation of a transparent film without any color using SiO of a sublimating type allowing uniform vapor deposition as the target material.

Preferably, the magnet is in an elongated shape. According to this configuration, it is possible to form a film over a wide substrate.

Preferably, a shielding plate is provided at a position facing the magnet with the substrate interposed therebetween. According to this configuration, it is possible to prevent a colored film made of SiO from being formed over the area of the substrate where the plasma confining space is not defined.

Preferably, the magnet is disposed such that a long side thereof comes near and along an edge of the substrate. According to this configuration, an entire surface of the vapor deposition surface of the substrate may be disposed within the plasma confining space. Then, it is possible to perform film formation of a transparent film without any color over the entire surface of the vapor deposition surface of the substrate, using SiO of a sublimating type allowing uniform vapor deposition as the target material.

Preferably, a plurality of magnets are disposed in a direction of transferring the substrate. It is also preferable that the substrate is configured to rotate during film formation about a center line perpendicular to the vapor deposition surface, and the magnet is disposed at a position distant from the center line. According to these configurations, an SiO₂ film with a higher degree of reaction and an SiO₂ film with a lower degree of reaction may be stacked.

### EFFECTS OF THE INVENTION

According to the present invention, as evaporated SiO is reacted with plasma and activated in a plasma confining space, a film made of SiO₂ may be formed over a vapor deposition surface of a substrate without using oxygen as a reaction gas. In other words, it is possible to perform film formation of a transparent film without any color using SiO of a sublimating type allowing uniform vapor deposition as a target material.

### BRIEF DESCRIPTION OF THE DRAWINGS

Fig. 1 is a schematic diagram illustrating a film formation device according to a first embodiment of the present invention.
Fig. 2 is a diagram illustrating a plasma confining space defined by a magnet disposed on a back surface of a substrate.
Fig. 3 is a diagram illustrating a main part of the film formation device according to a second embodiment of the present invention.
Fig. 4 is a diagram illustrating a main part of the film formation device according to a third embodiment of the present invention.
Fig. 5 is a diagram illustrating a main part of the film formation device according to a fourth embodiment of the present invention.
Fig. 6 is a schematic diagram illustrating the film formation device according to a fifth embodiment of the present invention.
Fig. 7 is a diagram illustrating a positional relation between the substrate that is rotatably supported and the magnet.
Fig. 8 is a diagram illustrating a modified example of the film formation device of the present invention.
Fig. 9(a) is a diagram illustrating a modified example of the film formation device of the present invention, and Fig. 9(b) is a side view illustrating a main part thereof.
Fig. 10 is a diagram showing positions for measuring transmissivity of the substrate.

### EMBODIMENTS OF THE INVENTION

Hereinafter, embodiments of the present invention will be described with reference to the drawings.

### FIRST EMBODIMENT

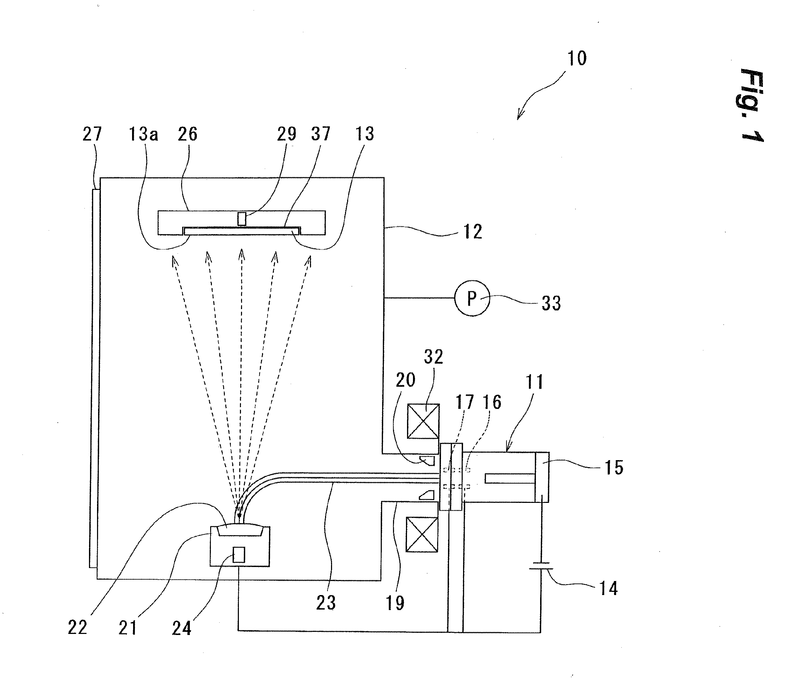

Fig. 1 shows a film formation device according to a first embodiment of the present invention. A film formation device 10 is an ion plating device, and causes a plasma gun (plasma generating device) 11 to generate plasma within a film formation chamber 12 to form a thin film over a substrate 13 by vapor deposition.

The plasma gun 11 is a pressure gradient plasma gun. The plasma gun 11 includes a cathode 15 connected to a negative side of a discharge power source 14, and intermediate electrodes 16 and 17 connected to a positive side of the discharge power source 14. The cathode 15 and the intermediate electrodes 16 and 17 are disposed annularly so that a discharge gas supplied to the plasma gun 11 may be injected into the film formation chamber 12 through a hole in a center of the cathode 15.

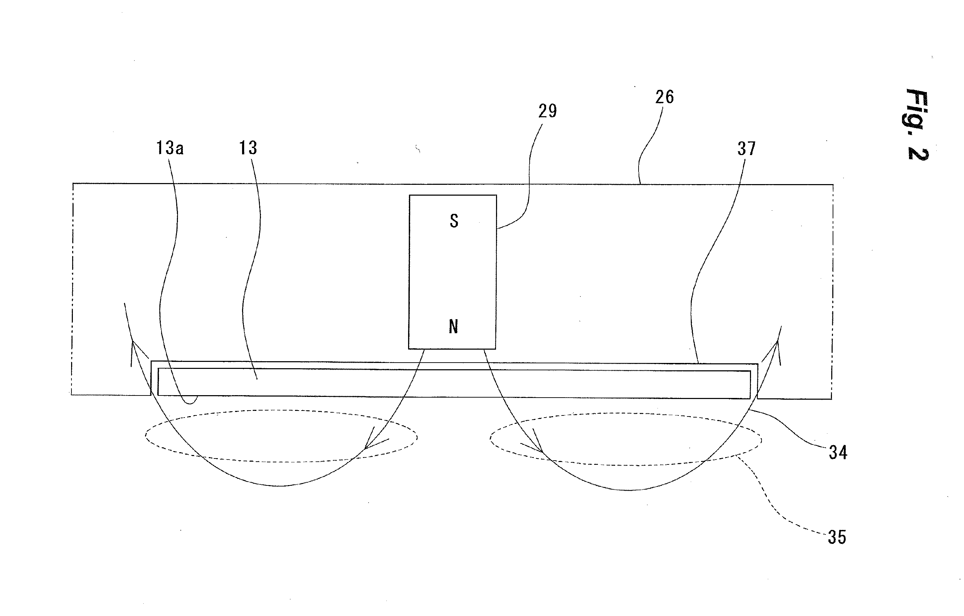

The film formation chamber 12 is a box-shaped body provided substantially in a cuboid. On a side surface of the film formation chamber 12, there is provided a substantially cylindrical plasma gun attachment section 19 that projects outwardly substantially in a horizontal direction so as to communicate inside and outside of the chamber. In an interior of the plasma gun attachment section 19, an annular electron feedback electrode 20 is provided at an area corresponding to an area radially outside an opening of the intermediate electrodes 16 and 17. At a lower side within the film formation chamber 12, there is provided a crucible 21 connected to the positive side of the discharge power source 14. The crucible 21 contains a target material 22 for forming a thin film made of an insulating material over a vapor deposition surface 13a of the substrate 13. The target material 22 is SiO. In the crucible 21, there is provided a crucible magnet 24 for attracting a plasma beam 23. In the film formation chamber 12, the plasma beam 23 irradiated by the plasma gun 11 substantially in the horizontal direction is flexed toward the crucible magnet 24 in the crucible 21 so that the target material 22 is irradiated with the plasma. At an upper side within the film formation chamber 12 that faces the crucible 21, there is provided a processing unit 26 on which the substrate 13 is placed such that the vapor deposition surface 13a of the substrate 13 faces an interior of the film formation chamber 12. The film formation chamber 12 is provided with a door 27, so that the substrate 13 may be replaced or the target material 22 may be added. Airtightness within the film formation chamber 12 is ensured by closing the door 27. The processing unit 26 is provided with an elongated plasma confining magnet 29 on a back surface of the substrate 13 which is an opposite side from the crucible 21. As illustrated in Fig. 2, the plasma confining magnet 29 is disposed such that its long side along a center line of the substrate 13 and its N pole is directed toward a side of the substrate 13. An end surface of the plasma gun attachment section 19 is closed with the plasma gun 11 being attached so as to emit a plasma beam substantially in the horizontal direction. Around the plasma gun attachment section 19, a focusing coil 32 is provided along its outer circumference. A substrate placement section 37 is disposed so that its center corresponds to the plasma confining magnet 29. The film formation chamber 12 is connected to a vacuum pump 33 for exhausting a gas within the chamber.

After opening the door 27 of the film formation device 10, the substrate 13 is attached such that the vapor deposition surface 13a faces the interior of the film formation chamber 12, that is, toward the crucible 21. Then, after the door 27 is closed and the pressure is reduced by the vacuum pump 33, the discharge power source 14 is activated. This generates plasma of a discharge gas by the plasma gun 11, and SiO as the target material 22 is irradiated with a part of the generated plasma and evaporated. As illustrated in Fig. 2, a part of plasma generated within the film formation chamber 12 moves so that a relatively large amount of plasma is present near a magnetic line 34 of the plasma confining magnet 29 of the processing unit 26. In other words, a plasma confining space 35 due to a magnetic field of the plasma confining magnet 29 is defined near the vapor deposition surface 13a of the substrate 13. Accordingly, in the plasma confining space 35, SiO evaporated from the target material 22 in the crucible 21 reacts with plasma and SiO is activated. This forms SiO₂ over the vapor deposition surface 13a of the substrate 13. Specifically, a film of SiO₂ is formed over the vapor deposition surface 13a of the substrate 13 without using oxygen as a reaction gas.

According to the present invention, as plasma is confined so that more plasma is present within the plasma confining space 35 than around the plasma confining space 35, it is possible to promote reaction of SiO evaporated from the target material 22 in the crucible 21 with plasma. Specifically, it is possible to activate SiO by causing reaction of the evaporated SiO with plasma. Therefore, a film of SiO₂ may be formed over the vapor deposition surface 13a of the substrate 13 without using oxygen as a reaction gas. In other words, it is possible to perform film formation of a transparent film without any color using SiO of a sublimating type allowing uniform vapor deposition as the target material 22. Further, it is possible to form a film over the substrate 13 more stably, more efficiently, and with higher quality.

As the plasma confining magnet 29 is in an elongated shape, it is possible to form a film over the wide substrate 13.

As the plasma confining magnet 29 is disposed such that its long side is along the center line of the substrate 13, it is possible to perform film formation over a widest range of the substrate 13.

### SECOND EMBODIMENT

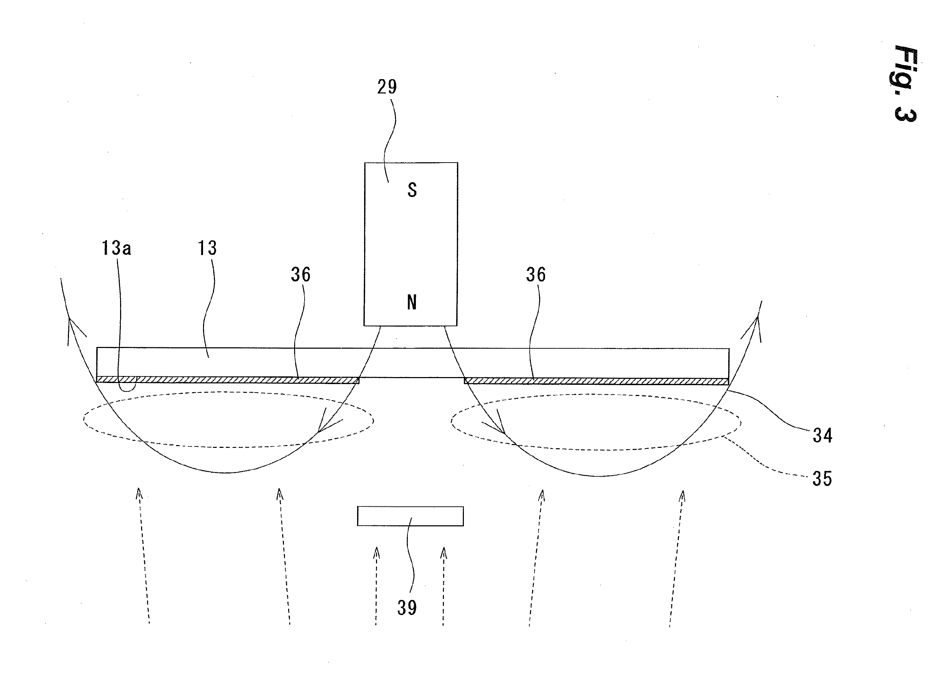

Fig. 3 shows a main part of the film formation device 10 according to a second embodiment of the present invention. In the film formation chamber 12, a shielding plate 39 is provided at a position facing against the plasma confining magnet 29 with the substrate 13 interposed therebetween.

According to this configuration, the shielding plate 39 is provided at the position facing against the plasma confining magnet 29 with the substrate 13 interposed therebetween, that is, a position facing against an area of the substrate 13 where the plasma confining space 35 is not defined. Therefore, it is possible to prevent the evaporated SiO from reaching the vapor deposition surface 13a of the substrate 13 without being activated within the plasma confining space 35, and thus to perform film formation only of a thin film 36 made of transparent SiO₂. Therefore, it is possible to prevent a colored film made of SiO from being formed over the area of the substrate 13 where the plasma confining space 35 is not defined.

### THIRD EMBODIMENT

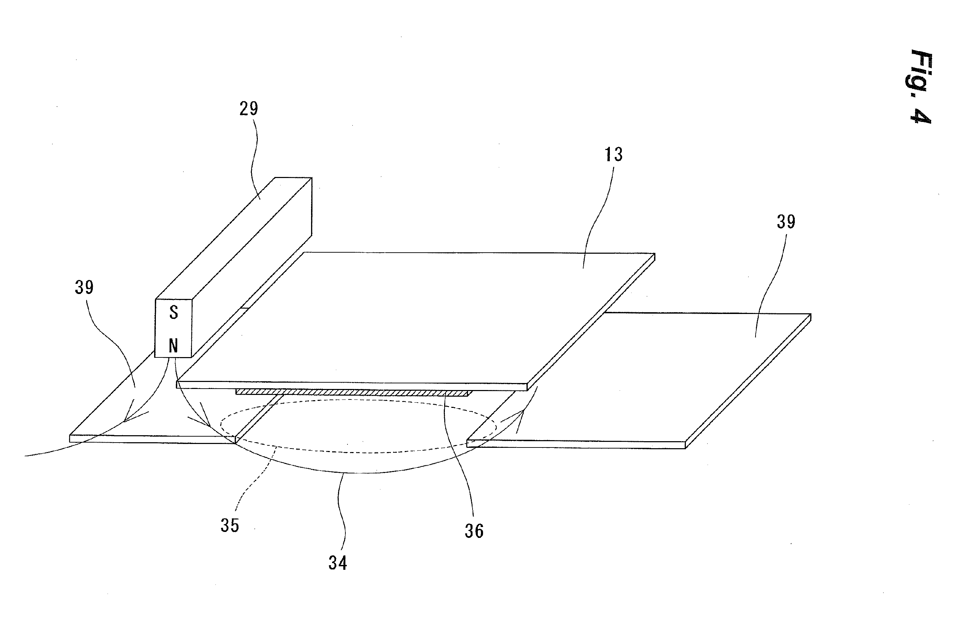

Fig. 4 shows a main part of the film formation device 10 according to a third embodiment of the present invention. The plasma confining magnet 29 is disposed such that its long side comes near and along an edge of the substrate 13. According to this configuration, an entire surface of the vapor deposition surface 13a of the substrate 13 may be disposed within the magnetic line 34, that is, within the plasma confining space 35. Therefore, it is possible to perform film formation of a transparent film without any color over the entire surface of the vapor deposition surface 13a of the substrate 13, using SiO of a sublimating type allowing uniform vapor deposition as the target material 22. Similarly, the shielding plate 39 is disposed in an area where the plasma confining space 35 is not defined.

### FOURTH EMBODIMENT

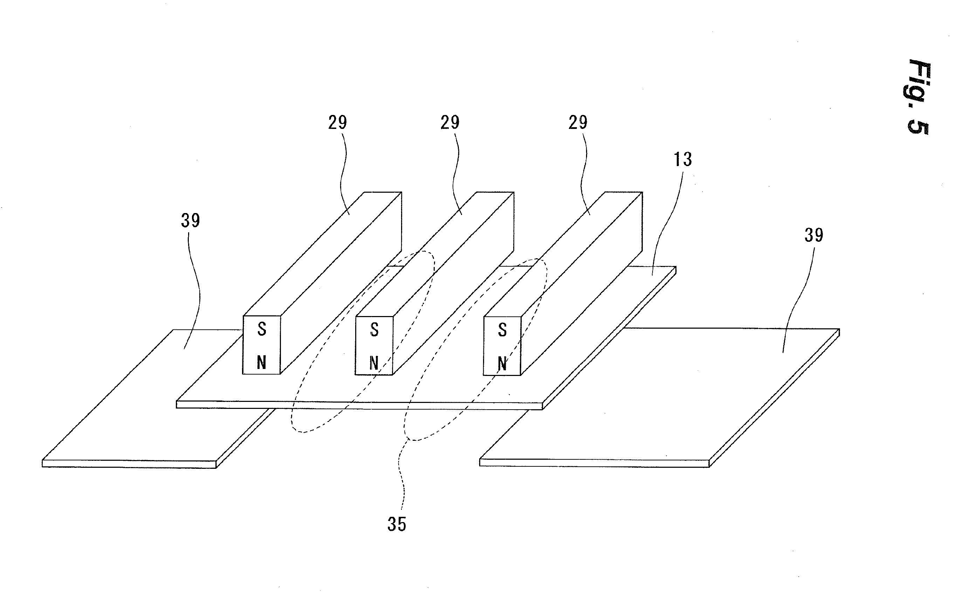

Fig. 5 shows a main part of the film formation device 10 according to a fourth embodiment of the present invention. A plurality of plasma confining magnets 29 are disposed in a direction of transferring the substrate 13. According to this configuration, in the transfer direction, an SiO₂ film with a higher degree of reaction and an SiO₂ film with a lower degree of reaction may be formed alternately over the vapor deposition surface 13a of the substrate 13.

### FIFTH EMBODIMENT

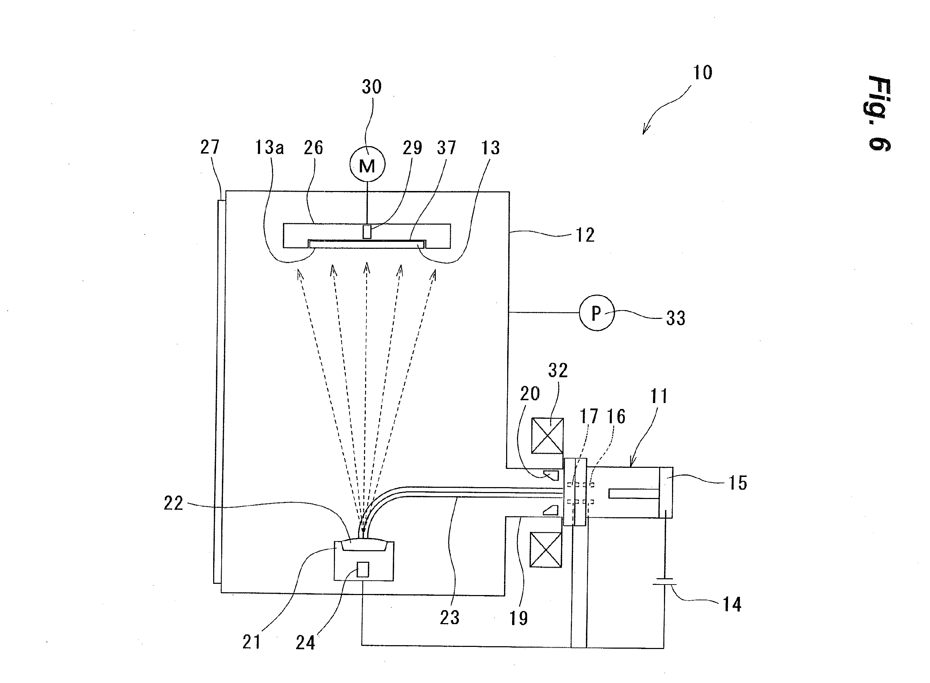

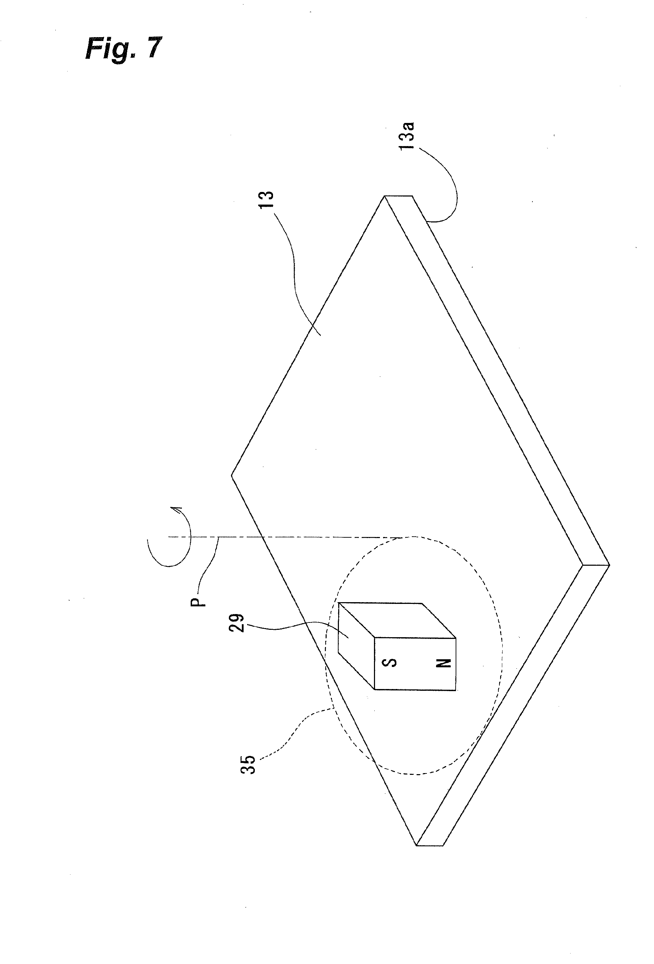

Fig. 6 shows the film formation device according to a fifth embodiment of the present invention. The processing unit 26 is coupled to a rotational shaft of the motor 30. Fig. 7 shows a main part of the film formation device 10 according to the fifth embodiment. The plasma confining magnet 29 is disposed at a position decentering with respect to the rotational shaft of the motor 30. As the motor 30 rotates, the substrate 13 also rotates about an axis line P. With this, film formation is performed while the substrate 13 repeatedly moves closer to and away from the plasma confining space 35 defined centering the plasma confining magnet 29. According to this configuration, similarly, an SiO₂ film with a higher degree of reaction and an SiO₂ film with a lower degree of reaction may be formed alternately over the vapor deposition surface 13a of the substrate 13.

It should be appreciated that the film formation device 10 according to the present invention is not limited to the embodiments described above, and may be modified in a variety of manners as described below.

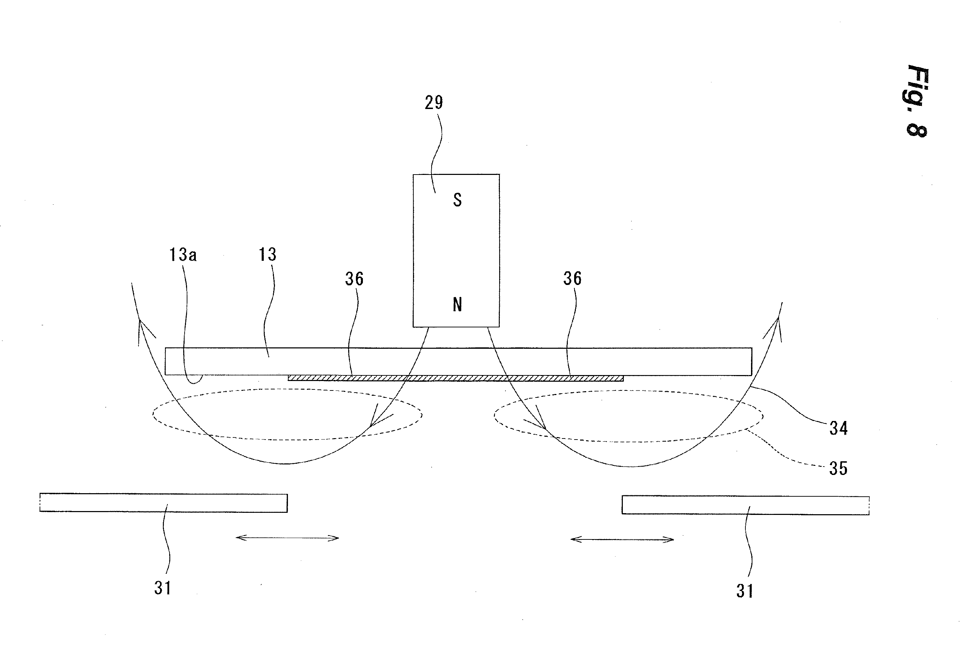

As illustrated in Fig. 8, the film formation chamber 12 may be provided with a shutter 31 that is movable substantially in the horizontal direction between the processing unit 26 and the crucible 21. According to this configuration, by adjusting a degree of opening of the shutter 31, it is possible to expand or contract an area for film formation over the vapor deposition surface 13a of the substrate 13.

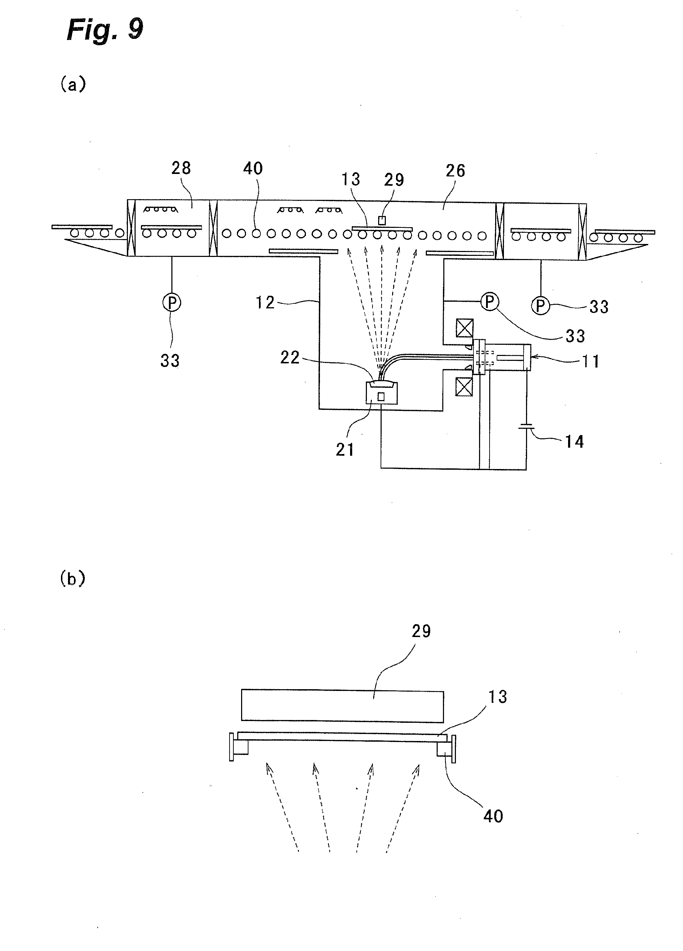

As illustrated in Fig. 9(a), the processing unit 26 of the film formation device 10 may be provided so as to extend substantially in the horizontal direction, and the processing unit 26 may be provided with a transfer unit 40 that is transferrable substantially in the horizontal direction. Fig. 9(b) is a side view illustrating a side-sectional view at a position of the magnet 29. According to this configuration, substrates 13 may be transferred by the transfer unit 40 at predetermined intervals from a transfer chamber 28, and film formation may be performed to the substrates 13 by the processing unit 26. Specifically, film formation may be successively performed to the substrates 13.

Further, as the present invention may be applied to a roll-type film formation device for successively supplying the substrate 13 along a roll, it is also possible to perform film formation to a resin film or the like.

### EXPERIMENTAL EXAMPLES

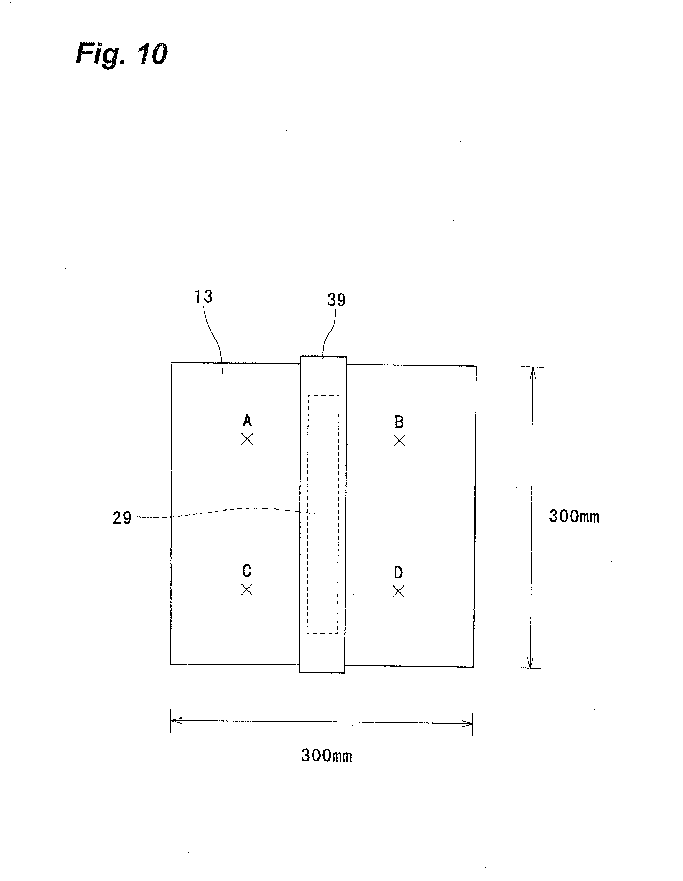

In order to confirm an effect of film formation with the plasma confining magnet 29 provided for the back surface of the substrate 13, experiments were performed under the following conditions (Table 1). Specifically, it was investigated how transmissivity (%) of the substrate 13 in film formation with the plasma confining magnet 29 changes as compared to transmissivity (%) of a substrate in film formation without the plasma confining magnet 29. As the substrate, transparent glass was used for all cases. The magnet 29 was provided so that its N pole came near a center of a 300 (mm) × 300 (mm) substrate. The elongated shielding plate 39 was provided along a center line of the substrate at a position facing against the magnet with the substrate interposed therebetween. As illustrated in Fig. 10, transmissivity on the substrate were measured at positions indicated by A to D. Time duration for film formation was the same.

**[Table 1]**

| | Magnet | Electrical Power (kW) | Pressure (Pa) | Measurement Position | Film Thickness (nm) | Transmissivity (%) |
|---|---|---|---|---|---|---|
| Comparative Example | Not provided | 12.2 | 0.12 | A | 406.8 | 71.5 |
| | | | | B | 417.0 | 57.0 |
| | | | | C | 387.6 | 80.6 |
| | | | | D | 404.0 | 59.4 |
| Experiment 1 | Provided | 12.2 | 0.12 | A | 129.0 | 91.6 |
| | | | | B | 161.0 | 91.4 |
| | | | | C | 194.0 | 91.4 |
| | | | | D | 158.0 | 91.2 |
| Experiment 2 | Provided | 12.2 | 0.08 | A | 216.0 | 89.8 |
| | | | | B | 209.0 | 90.1 |
| | | | | C | 229.0 | 89.7 |
| | | | | D | 216.0 | 90.8 |
| Experiment 3 | Provided | 14.2 | 0.12 | A | 159.0 | 91.1 |
| | | | | B | 175.0 | 91.2 |
| | | | | C | 224.0 | 90.3 |
| | | | | D | 228.0 | 90.4 |
| Experiment 4 | Provided | 16.2 | 0.12 | A | 197.0 | 91.0 |
| | | | | B | 213.0 | 90.9 |
| | | | | C | 262.0 | 89.8 |
| | | | | D | 202.0 | 91.3 |

### COMPARATIVE EXAMPLE

Transmissivity of the substrate was measured without providing a magnet for the back surface of the substrate. Regarding the measurement conditions, the electrical power was 12.2 (kW), and the pressure was 0.12 (Pa). As shown in Table 1, the transmissivity at A, B, C, and D were 71.5%, 57.0%, 80. 6%, and 59.4%. The film was colored at all of the points A, B, C, and D.

### EXPERIMENT 1

Transmissivity of the substrate was measured with the magnet provided in the center of the back surface of the substrate. Regarding the measurement conditions, the electrical power was 12.2 (kW), and the pressure was 0.12 (Pa). The transmissivity at A, B, C, and D were 91.6%, 91.4%, 91.4%, and 91.2%. The film was not colored at any of the points A, B, C, and D.

### EXPERIMENT 2

Transmissivity of the substrate was measured with the magnet provided in the center of the back surface of the substrate. Regarding the measurement conditions, the electrical power was 12.2 (kW), and the pressure was 0.08 (Pa) . The transmissivity at A, B, C, and D were 89.8%, 90.1%, 89.7%, and 90.8%. The film was not colored at any of the points A, B, C, and D.

### EXPERIMENT 3

Transmissivity of the substrate was measured with the magnet provided in the center of the back surface of the substrate. Regarding the measurement conditions, the electrical power was 14.2 (kW), and the pressure was 0.12 (Pa). The transmissivity at A, B, C, and D were 91.1%, 91.2%, 90.3%, and 90.4%. The film was not colored at any of the points A, B, C, and D.

### EXPERIMENT 4

Transmissivity of the substrate was measured with the magnet provided in the center of the back surface of the substrate. Regarding the measurement conditions, the electrical power was 16.2 (kW), and the pressure was 0.12 (Pa). The transmissivity at A, B, C, and D were 91.0%, 90.9%, 89.8%, and 91.3%. The film was not colored at any of the points A, B, C, and D.

As described above, it is determined that the transmissivity of the substrate in the experiments 1-4 in which the magnet was provided in the back surface of the substrate was basically about 90% regardless of magnitudes of the electrical power and the pressure, while the transmissivity of the substrate in the comparative example in which a magnet was not provided for the back surface of the substrate was in a range between 57.0 (%) and 80.6 (%), falling well below 90 (%). As a result, it is confirmed that by providing the plasma confining magnet 29 for the back surface of the substrate 13, it is possible to perform film formation of a transparent film without any color using SiO of a sublimating type allowing uniform vapor deposition as the target material 22. The transmissivity in the experiments 1-4 was about 90%. As this value is substantially the same as transmissivity of the glass used as a base, a formed thin film itself is considered to have transmissivity close to 100%. It is not possible to make an easy comparison of a difference in transmissivity, as the film thickness in the experiments 1-4 is about half of that of the comparative example. However, even doubling the thickness of a thin film having transmissivity close to 100% should not change the transmissivity largely. Therefore, from the experiments, it is apparent that transmissivity of thin films was improved.

Further, in the comparative example, the transmissivity took different values at the points A to D as no magnet was provided, but the values of the transmissivity in the experiments 1-4 were substantially the same. It is considered that this, in the case in which no magnet was provided, was a result of ununiform film formation at the points A to D as an area in which evaporated SiO was activated was not provided in this case. It is also considered that this, in the case in which the magnet was provided, was a result of uniform film formation in which the plasma confining space 35 was defined around magnetic lines extending radially from the magnet. In addition, while the time duration of film formation was the same, it is confirmed that the thickness of the film formed with the magnet provided for the back surface of the base (129.0 mm to 262.0 mm) was thinner than the thickness of the film formed without providing a magnet for the back surface of the base (387.6 mm to 417.0 mm).

### DESCRIPTION OF REFERENCE SIGNS

10: Film formation device
11: Plasma gun (plasma generating device)
12: Film formation chamber
13: Substrate
13a: Vapor deposition surface
14: Discharge power source
15: Cathode
16, 17: Intermediate electrode
19: Plasma gun attachment section
20: Electron feedback electrode
21: Crucible
22: Target material
23: Plasma beam
24: Crucible magnet
26: Processing unit
27: Door
28: Transfer chamber
29: Plasma confining magnet
30: Motor
31: Shutter
32: Focusing coil
33: Vacuum pump
34: Magnetic line
35: Plasma confining space
36: Thin film
37: Substrate placement section
39: Shielding plate
40: Transfer unit

## Claims

1. A film formation method comprising the steps of:
preparing a substrate such that a vapor deposition surface of the substrate faces an interior of a film formation chamber;
providing a magnet for a back surface of the substrate;
placing SiO on a crucible disposed in the film formation chamber;
irradiating the SiO with plasma by a plasma generating device to evaporate SiO;
defining a plasma confining space on a side of the vapor deposition surface of the substrate by a magnetic field of the magnet; and
forming SiO₂ by causing reaction of the evaporated SiO with plasma in the plasma confining space and activating SiO, and thus forming an SiO₂ film over the vapor deposition surface of the substrate without using oxygen as a reaction gas.

2. A film formation device capable of performing film formation by irradiating a target material placed on a crucible in a film formation chamber with plasma by a plasma generating device to evaporate the target material, and performing vapor deposition of the evaporated target material over a substrate provided such that a vapor deposition surface of the substrate faces an interior of the film formation chamber, wherein
an SiO₂ film is formed over the vapor deposition surface of the substrate without using oxygen as a reaction gas by:
providing a magnet for a back surface of the substrate, defining a plasma confining space on a side of the vapor deposition surface of the substrate by a magnetic field of the magnet, and placing SiO as a target material on the crucible; and
irradiating the SiO with plasma by a plasma generating device to evaporate SiO, and forming SiO₂ by causing reaction of the evaporated SiO with plasma in the plasma confining space and activating SiO.

3. The film formation device according to claim 2, wherein
the magnet is in an elongated shape.

4. The film formation device according to claim 2, wherein
a shielding plate is provided at a position facing the magnet with the substrate interposed therebetween.

5. The film formation device according to claim 3, wherein
the magnet is disposed such that a long side thereof comes near and along an edge of the substrate.

6. The film formation device according to claim 2, wherein
a plurality of magnets are disposed in a direction of transferring the substrate.

7. The film formation device according to claim 2, wherein
the substrate is configured to rotate during film formation about a center line perpendicular to the vapor deposition surface, and the magnet is disposed at a position distant from the center line.
